# EUROPEAN PATENT APPLICATION

(11) **EP 3 534 521 A1**
(43) Date of publication of application: **04.09.2019**
(21) Application number: 17865178.2
(22) Date of filing: 05.10.2017
(51) Int. Cl.: H02M 7/12

(54) **RECTIFYING METHOD AND RECTIFYING DEVICE**

(30) Priority: 31.10.2016 JP 2016213915
(71) Applicant: Asahi Kasei Microdevices Corporation, Tokyo 1000006 (JP)
(72) Inventor: SAKAMOTO, Toshiro, Tokyo 101-8101 (JP); MORIZUMI, Masahiro, Tokyo 101-8101 (JP)
(74) Representative: Hoffmann Eitle
(86) International application number: PCT/JP2017/036394
(87) International publication number: WO 2018/079227

(57) **Abstract**

A rectifying device 100 includes: at least one MOSFET (PMOSFET 20) having a gate terminal 26a, a drain terminal 25a, and a well terminal 23 a that are interconnected; an AC signal generation source 80 that generates an AC signal to cause the at least one MOSFET to operate in a voltage region including a weak inversion region, and supplies the AC signal to a source terminal 24a of the MOSFET; and a capacitative element C connected to the drain terminal 25a of the MOSFET. As a rectifying element, a MOSFET that is driven even in a weak inversion region by short-circuiting the gate, drain, and well, and so have low rectification loss, and small leakage current is used; therefore, rectifying devices that are highly efficient, have low leakage current, can cope with high frequency, and thus are suitable for energy harvesting technologies to collect very weak energy are constituted.

## Description

### BACKGROUND

### 1. TECHNICAL FIELD

The present invention relates to a rectifying method and a rectifying device.

### 2. RELATED ART

Energy harvesting technologies to collect (harvest) very weak energy existing in an environment, and convert the energy into electrical power have been known. Sources of energy to be used in this type of technology include those that generate DC (that is, DC voltage) as in solar power generation and thermal power generation, and those that generate AC (that is, AC voltage) as in vibration power generation and radio wave power generation. In the case of AC, AC is converted into DC by a full-wave rectifying circuit including a diode bridge (also called a rectifying bridge circuit); thereby, power can be stored in a secondary battery, a capacitor, or the like (see Patent Literature 1, for example). On the other hand, a general synchronous rectifying circuit with controlling ON/OFF of a switching element by an external circuit cannot be employed for the purpose of converting very weak environmental energy into electrical power, and storing the electrical power, since it is difficult to spare electrical power for control. Accordingly, it is not possible to attempt to enhance efficiency of power storage by circuit control, and in order to improve the power storage efficiency, characteristics of a rectifying element itself need to be improved.

It is desired that a rectifying element constituting the above-mentioned diode bridge have a lower forward rising voltage (simply called a rising voltage in some cases) Vf, small reverse leakage current (simply called leakage current in some cases) Ir, and a short reverse recovery time. A low rising voltage Vfreduces rectification loss, small leakage current Ir enables accumulation of sufficient charges, and a short reverse recovery time makes it possible to follow high frequency AC; as a result, it becomes possible to convert very weak energy into electrical power efficiently. In view of this, generally, a diode bridge is often constituted using discrete components such as a Schottky barrier diode with favorable rising characteristics and low Vf, or a silicon diode with low leakage current Ir.

[Patent Literature 1] Japanese Patent Application Publication No. 2010-172111

However, a Schottky barrier diode has favorable rising characteristics on one hand, but has large leakage current, a silicon diode has small leakage current on one hand, but has slow rising characteristic, and high Vf, and so they are not necessarily suitable for reducing rectification loss to thereby improve power storage efficiency. In addition, there are difficulties related to designs of board substrates, for example that the space for incorporating discrete components is required, and so on.

### [General Disclosure]

(Item 1)
   A rectifying method may include: supplying an AC signal to cause a MOSFET having a gate terminal, a drain terminal, and a well terminal that are interconnected to operate in a voltage region including a weak inversion region to one of a source terminal and the drain terminal of the MOSFET.
   The rectifying method may include obtaining a DC signal obtained through rectification of the AC signal by the MOSFET from the other one of the source terminal and the drain terminal.
(Item 2)
   Reverse leakage current of the MOSFET may be smaller than 1 nA.
(Item 3)
   The MOSFET may be integrated on an energy harvesting IC.
(Item 4)
   A rectifying device may include at least one MOSFET having a gate terminal, a drain terminal, and a well terminal that are interconnected. The rectifying device may include an AC signal generation source that generates an AC signal to cause the at least one MOSFET to operate in a voltage region including a weak inversion region, and supplies the AC signal to one of a source terminal and the drain terminal of the MOSFET. The rectifying device may include a capacitative element connected to the other one of the source terminal and the drain terminal.
(Item 5)
   Reverse leakage current of the at least one MOSFET may be smaller than 1 nA.
(Item 6)
   The at least one MOSFET may be integrated on an energy harvesting IC.
(Item 7)
   The capacitative element may be integrated on the energy harvesting IC.
(Item 8)
   The at least one MOSFET may include a MOSFET having a well which is connected to the well terminal, the well being isolated from a substrate.
(Item 9)
   The at least one MOSFET may include two NMOSFETs and two PMOSFETs between which diode bridge connections are established.
(Item 10)
   The at least one MOSFET may include four NMOSFETs between which diode bridge connections are established.
(Item 11)
   At least one of the four NMOSFETs may have an isolation region that isolates a well connected to the well terminal from a substrate.
   The isolation region may be connected to one end of the capacitative element.
(Item 12)
   The at least one MOSFET may include four PMOSFETs between which diode bridge connections are established.

The summary clause does not necessarily describe all necessary features of the embodiments of the present invention. The present invention may also be a sub-combination of the features described above.

### BRIEF DESCRIPTION OF THE DRAWINGS

FIG. 1A illustrates the structure of a MOSFET (NMOSFET) used in a rectifying device according to the present embodiment.
FIG. 1B illustrates the circuit configuration of the MOSFET illustrated in FIG. 1A.
FIG. 2A illustrates the structure of another MOSFET (PMOSFET) used in a rectifying device according to the present embodiment.
FIG. 2B illustrates the circuit configuration of the MOSFET illustrated in FIG. 2A.
FIG. 3 illustrates an exemplary diode connection of the NMOSFET.
FIG. 4 illustrates an exemplary diode connection of the PMOSFET.
FIG. 5 schematically illustrates current/voltage characteristics of the diode-connected MOSFET.
FIG. 6 illustrates current/voltage characteristics obtained with the diode-connected MOSFET.
FIG. 7 illustrates the circuit configuration of the rectifying device according to the present embodiment.
FIG. 8A illustrates principles of operation of the rectifying device according to the present embodiment.
FIG. 8B illustrates principles of operation of the rectifying device according to the present embodiment (when signals of opposite phases are generated).
FIG. 9 illustrates output from rectification, by the rectifying device according to the present embodiment, of AC signals in vibration power generation.
FIG. 10 illustrates an amount of power stored by storing, using the rectifying device according to the present embodiment, AC signals in vibration power generation.
FIG. 11 illustrates the flow of a rectifying method performed by the rectifying device according to the present embodiment.
FIG. 12 illustrates the circuit configuration of a rectifying device according to a first variant.
FIG. 13 illustrates the circuit configuration of a rectifying device according to a second variant.
FIG. 14A illustrates principles of operation of the rectifying device according to the second variant.
FIG. 14B illustrates principles of operation of the rectifying device according to the second variant (when signals of opposite are generated).
FIG. 15 illustrates the circuit configuration of a rectifying device according to a third variant.
FIG. 16 illustrates the circuit configuration of a rectifying device according to a fourth variant.
FIG. 17A illustrates principles of operation of the rectifying device according to the fourth variant.
FIG. 17B illustrates principles of operation of the rectifying device according to the fourth variant (when signals of opposite are generated).
FIG. 18 illustrates the circuit configuration of a rectifying device according to a fifth variant.

### DESCRIPTION OF EXEMPLARY EMBODIMENTS

Hereinafter, (some) embodiment(s) of the present invention will be described. The embodiment(s) do(es) not limit the invention according to the claims, and all the combinations of the features described in the embodiment(s) are not necessarily essential to means provided by aspects of the invention.

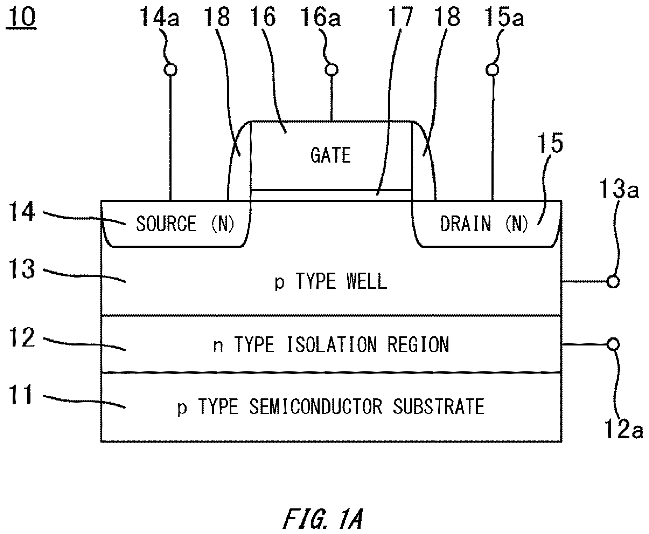

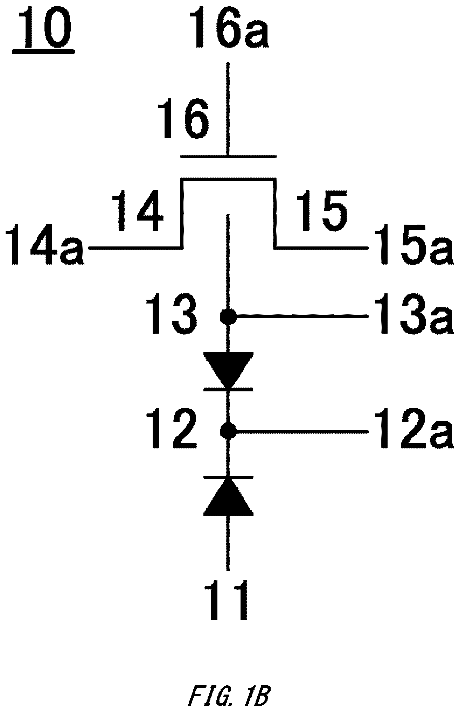

FIG. 1A and FIG. 1B illustrate the structure and circuit configuration of an insulated gate field effect transistor (MOSFET) used in a rectifying device 100 according to the present embodiment. This MOSFET is a planar gate n channel MOSFET (referred to as an NMOSFET) 10, for example, and has a triple-well structure including a p type semiconductor substrate 11, an n type isolation region 12, and a p type well 13. The n type isolation region 12 and p type well 13 are sequentially formed on the p type semiconductor substrate 11; thereby, the p type well 13 is isolated from the p type semiconductor substrate 11 by the n type isolation region 12, and a surface element structure of the NMOSFET 10 is provided on the upper surface of the p type well 13. Note that two diode symbols in FIG. 1B represent a PN structure between the p type semiconductor substrate 11 and the n type isolation region 12, and a PN structure between the n type isolation region 12 and the p type well 13, respectively.

The surface element structure of the NMOSFET 10 has an n type source region (source) 14, an n type drain region (drain) 15, a gate 16, a spacer 18, a source terminal 14a, a drain terminal 15a, a gate terminal 16a, an isolation terminal 12a, and a well terminal 13a. The source 14 and drain 15 are disposed on one side and the other side on a surface of the p type well 13 (that is, on the left side and the right side in the figure), respectively. The gate 16 is disposed on the middle of the p type well 13 with an insulating film 17 being interposed therebetween. The spacer 18 is formed to cover the side surface of the gate 16. The source terminal 14a, drain terminal 15a, and gate terminal 16a are connected to the upper surfaces of the source 14, drain 15, and gate 16, respectively. The isolation terminal 12a and well terminal 13a are connected to the n type isolation region 12 and p type well 13, respectively. Note that parasitic diodes (not illustrated) are present between the source 14 and the p type well 13, and between the drain 15 and the p type well 13.

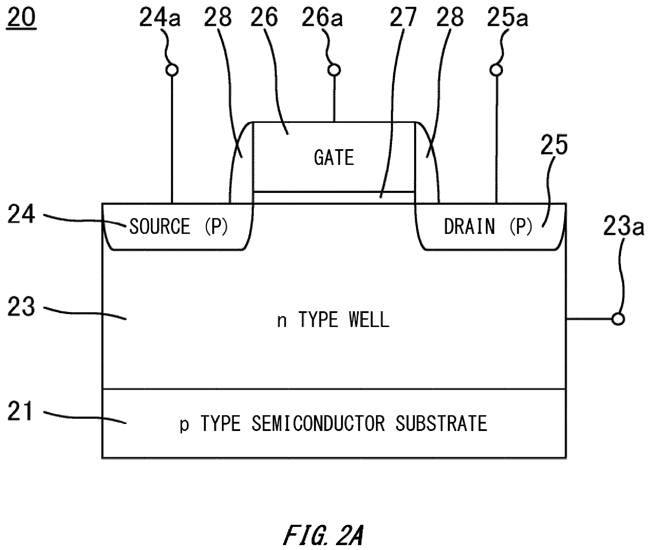

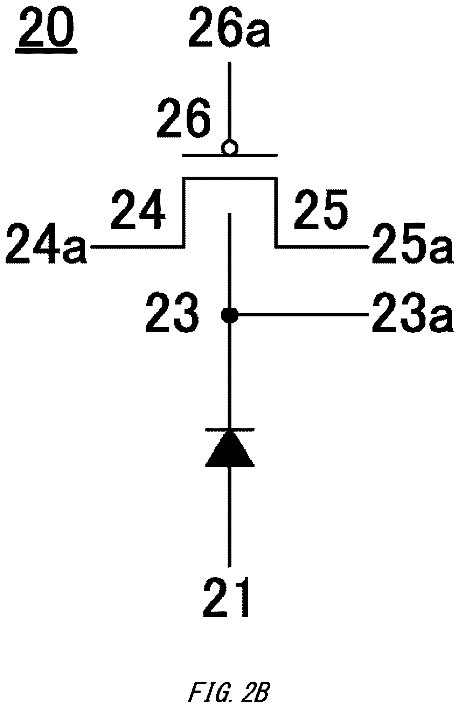

FIG. 2A and FIG. 2B illustrate the structure and circuit configuration of another insulated gate field effect transistor (MOSFET) used in the rectifying device 100 according to the present embodiment. This MOSFET is a planar gate p channel MOSFET (referred to as a PMOSFET) 20, for example, and includes a p type semiconductor substrate 21, and an n type well 23. The n type well 23 is formed on the p type semiconductor substrate 21, and a surface element structure of the PMOSFET 20 is provided on the upper surface of the n type well 23. Note that a diode symbol in FIG. 2B represents a PN structure between the p type semiconductor substrate 21 and the n type well 23.

The surface element structure of the PMOSFET 20 has a p type source region (source) 24, a p type drain region (drain) 25, a gate 26, a spacer 28, a source terminal 24a, a drain terminal 25a, a gate terminal 26a, and a well terminal 23a. The source 24 and drain 25 are disposed on one side and the other side on a surface of the n type well 23 (that is, on the left side and the right side in the figure), respectively. The gate 26 is disposed on the middle of the n type well 23 with an insulating film 27 being interposed therebetween. The spacer 28 is formed to cover the side surface of the gate 26. The source terminal 24a, drain terminal 25a, and gate terminal 26a are connected to the upper surfaces of the source 24, drain 25, and gate 26, respectively. The well terminal 23a is connected to the n type well 23. Note that parasitic diodes (not illustrated) are present between the source 24 and the n type well 23, and between the drain 25 and the n type well 23.

Note that although planar gate MOSFETs are used in the rectifying device 100 according to the present embodiment, this is not the sole example, and trench gate MOSFETs may be used. In addition, the MOSFET formed on the p type semiconductor substrate 11 or 21 is not the only MOSFET that can be used, but a MOSFET formed on an N type semiconductor substrate may be used.

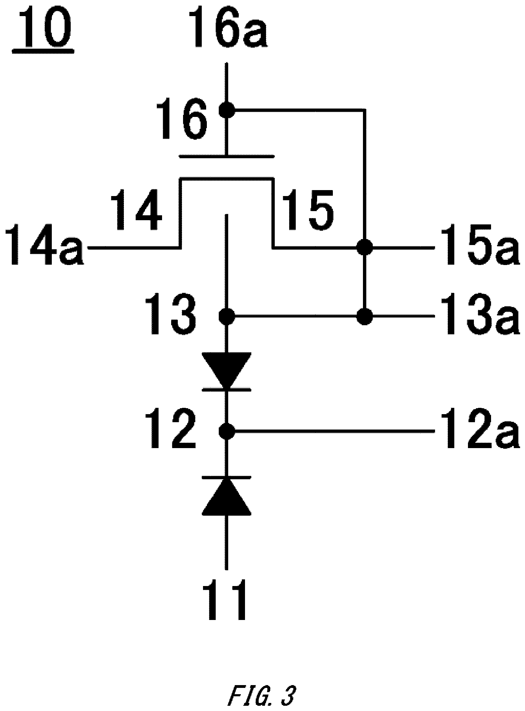

FIG. 3 illustrates an exemplary diode connection of the NMOSFET 10 used as a rectifying element in the rectifying device 100 according to the present embodiment. In the diode connection in the present example, the gate terminal 16a, drain terminal 15a, and well terminal 13a of the NMOSFET 10 are interconnected (that is, the gate 16, drain 15, and p type well 13 are short-circuited). Thereby, in the NMOSFET 10, the p type well 13 is at the same potential as the gate 16 and drain 15, and the NMOSFET 10 constitutes a rectifying element having the source 14 and drain 15 that function as the cathode and anode, respectively. That is, the NMOSFET 10 constitutes a rectifying element that receives input current at the drain 15 via the drain terminal 15a, rectifies the input current between the drain 15 and the source 14, and outputs the rectified current from the source 14 via the source terminal 14a. The thus-configured rectifying element shows excellent characteristics in terms of rising characteristics, leakage current, and reverse recovery time as described below.

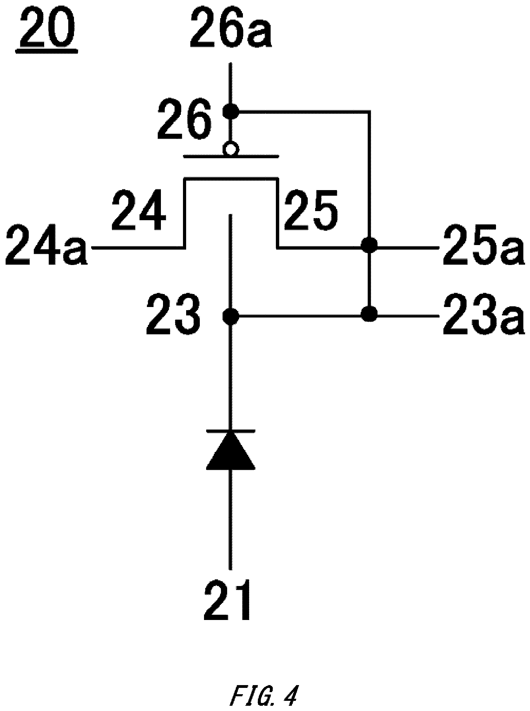

FIG. 4 illustrates an exemplary diode connection of the PMOSFET 20 used as a rectifying element in the rectifying device 100 according to the present embodiment. In the diode connection in the present example, the gate terminal 26a, drain terminal 25a, and well terminal 23 a of the PMOSFET 20 are interconnected (that is, the gate 26, drain 25, and n type well 23 are short-circuited). Thereby, in the PMOSFET 20, the n type well 23 is at the same potential as the gate 26 and drain 25, and the PMOSFET 20 constitutes a rectifying element having the source 24 and drain 25 that function as the anode and cathode, respectively. That is, the PMOSFET 20 constitutes a rectifying element that receives input current at the source 24 via the source terminal 24a, rectifies the input current between the source 24 and the drain 25, and outputs the rectified current from the drain 25 via the drain terminal 25a. The thus-configured rectifying element shows excellent characteristics in terms of rising characteristics, leakage current, and reverse recovery time as described below.

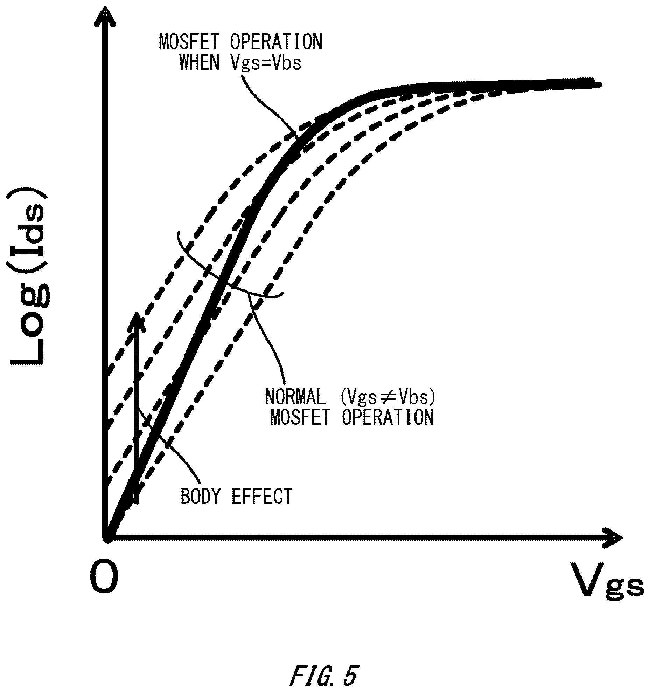

FIG. 5 schematically illustrates current/voltage characteristics of the diode-connected MOSFETs in the present example (that is, the NMOSFET 10 and PMOSFET 20). Note that, in the figure, current/voltage characteristics of a typically diode-connected MOSFET, in which the gate terminal and the drain terminal are connected, and the source terminal and the well terminal are connected, are shown as well, as a comparative example. Since, in the MOSFETs according to the present example, the well potential Vbs relative to the source is equal to the gate potential Vgs, and so the threshold varies depending on the potential of substrate (back gate) due to the body effect during operation, the MOSFETs according to the present example show current/voltage characteristics with a steep gradient of the drain current Ids in relation to the gate potential Vgs (that is, steep on/off characteristics) as indicated using a solid line in the figure. In contrast to this, in the MOSFET of the comparative example, the well potential Vbs becomes constant, and the MOSFET shows rising characteristics of typical MOSFETs as indicated using broken lines in the figure. For example, if a planar gate MOSFET configured using a Si semiconductor has the same configuration as that of the MOSFETs in the present example, rising characteristics in a weak inversion region (a voltage required for a ten-fold increase of current) which equal 60 mV/dec is obtained. On the other hand, the rising characteristics of the MOSFET in the comparative example are approximately 80 mV/dec.

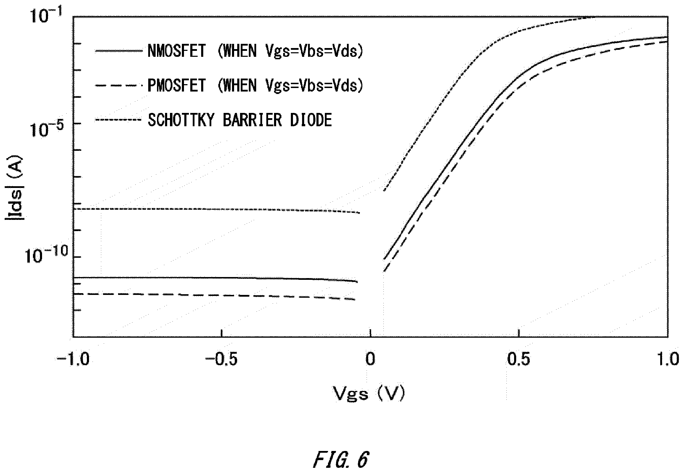

FIG. 6 illustrates current/voltage characteristics obtained with the diode-connected MOSFETs in the present example (that is, the NMOSFET 10 and PMOSFET 20). Note that, in the figure, current/voltage characteristics of a Schottky barrier diode is shown as well, as a comparative example. In the MOSFETs in the present example, similar to the Schottky barrier diode according to the comparative example, the current Ids increases at a steep gradient in relation to forward direction bias (Vgs>0), and the current Ids is constant in relation to reverse bias (Vgs<0). However, the current Ids is at least as small as several hundredths of that in the comparative example. Accordingly, the MOSFETs in the present example show favorable rising characteristics which are comparable to those of the Schottky barrier diode, and show leakage current (for example, smaller than 1 nA) smaller than that of the Schottky barrier diode. Note that leakage current at the time of turning-off of the MOSFETs can further be reduced by adjusting the threshold. In addition, if it is desired to increase the current Ids, this can be done by increasing the gate width W/the gate length L of a MOSFET. The MOSFETs that show the data shown in FIG. 6 have W/L which equals 1000 µm/1 µm.

Furthermore, since the MOSFETs are unipolar MOSFETs, the reverse recovery time of rectifying elements configured using diode connections is very short, and can also follow high frequency signals. Accordingly, the diode-connected MOSFETs in the present example can realize rectifying elements having low rising voltages (that is, steep rising characteristics), small leakage current, and short reverse recovery time. In addition, the rectifying elements in the present example can be driven even in a weak inversion region, and are useful in energy harvesting technologies that rectify µA-level current, for example. Furthermore, since the MOSFETs are used as rectifying elements, integration with other circuits is easy.

Note that the diode connections of the MOSFETs in the present example employ a similar use method of MOSFET to that for so-called DTMOSs (Dynamic Threshold MOSFETs). Here, DTMOSs are often disadvantageous in that, since the MOSFETs are driven in a voltage region where a forward direction voltage is applied to the source and well typically, a high voltage cannot be applied across the source and gate (that is, the well). However, since an object to be achieved with the rectifying device 100 according to the present embodiment is to attain a low rising voltage Vf, a high voltage is not applied across the source and gate (that is, the well); thereby, favorable rising characteristics can be obtained.

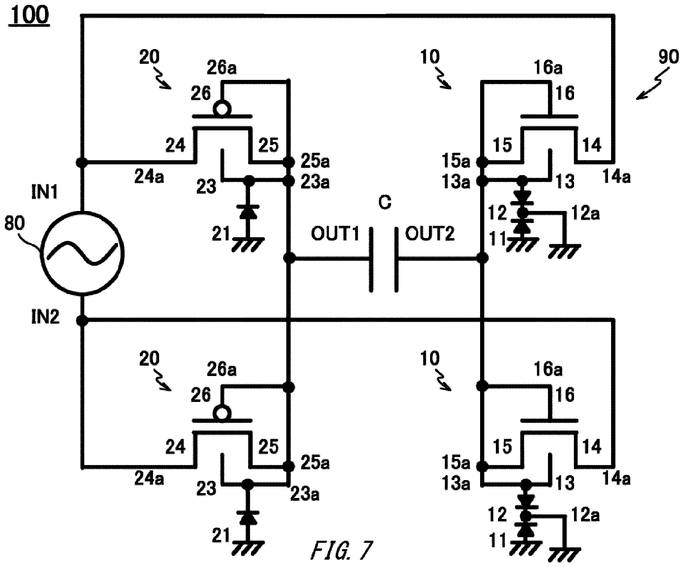

FIG. 7 illustrates the circuit configuration of the rectifying device 100 according to the present embodiment. An object to be achieved with the rectifying device 100 is to rectify AC signals and store power efficiently, and the rectifying device 100 includes an AC signal generation source 80, a rectifying bridge circuit 90, and a capacitative element C.

The AC signal generation source 80 is a voltage source that generates AC signals, and represents a generation source of environmental energy to be the subject of energy harvesting, or a converter that converts environmental energy into electrical power. The AC signal generation source 80 generates an AC signal to cause a diode-connected MOSFET (that is, the NMOSFET 10 shown in FIG. 3, and the PMOSFET 20 shown in FIG. 4) to operate in a voltage region including a weak inversion region, and supplies the AC signal to either the source terminal or drain terminal of the MOSFET in the present example constituting the rectifying bridge circuit 90, via two input terminals IN1 and IN2 of the rectifying bridge circuit 90 (in FIG. 7, the AC signal is supplied to the source terminal).

The rectifying bridge circuit 90 includes at least one MOSFET, that is, the NMOSFET 10 shown in FIG. 3 or the PMOSFET 20 shown in FIG. 4. In the present embodiment, the rectifying bridge circuit 90 includes two NMOSFETs 10 and two PMOSFETs 20, for example. The rectifying bridge circuit 90 has the two input terminals IN1 and IN2, and two output terminals OUT1 and OUT2, and between those terminals, diode bridge connections are established between the two NMOSFETs 10 and the two PMOSFETs 20. The two NMOSFETs 10 each have a source terminal 14a connected to the AC signal generation source 80 via the input terminals IN1 and IN2, and has a drain terminal 15a connected to the capacitative element C via the output terminal OUT2. In addition, the two NMOSFETs 10 each have an isolation terminal 12a (that is, an n type isolation region 12) connected to the ground. Note that the isolation terminal 12a may be connected to the output terminal OUT1. The two PMOSFETs 20 each have a source terminal 24a connected to the AC signal generation source 80 via the input terminals IN1 and IN2, and has a drain terminal 25a connected to the capacitative element C via the output terminal OUT1.

The capacitative element C is an element to store environmental energy, and is connected to the other one of the source terminal and drain terminal of at least one MOSFET constituting the rectifying bridge circuit 90 (connected to the drain terminal in FIG. 7). In the present embodiment, the capacitative element C is connected between the output terminals OUT1 and OUT2 of the rectifying bridge circuit 90, that is, between the drain terminals 15a of the two NMOSFETs 10 and the drain terminals 25a of the two PMOSFETs 20, for example. Note that another power storage element such as a secondary battery may be used instead of the capacitative element C.

Note that at least one of (at least one MOSFET constituting) the rectifying bridge circuit 90 and the capacitative element C may be integrated on an energy harvesting IC (not illustrated).

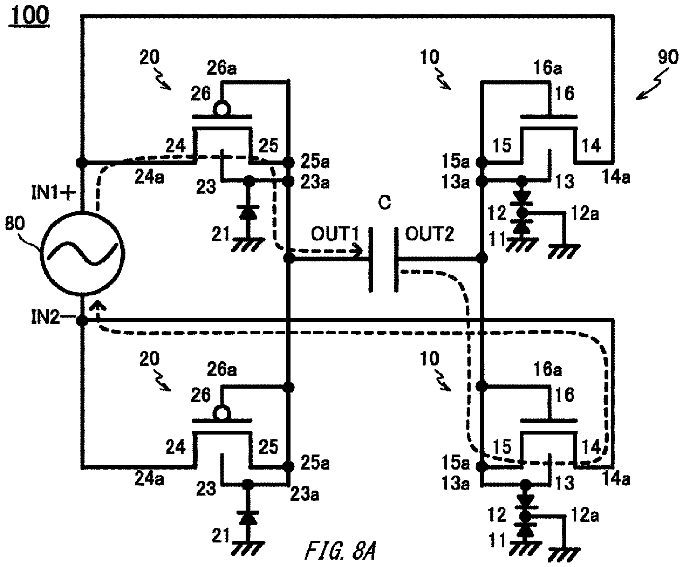

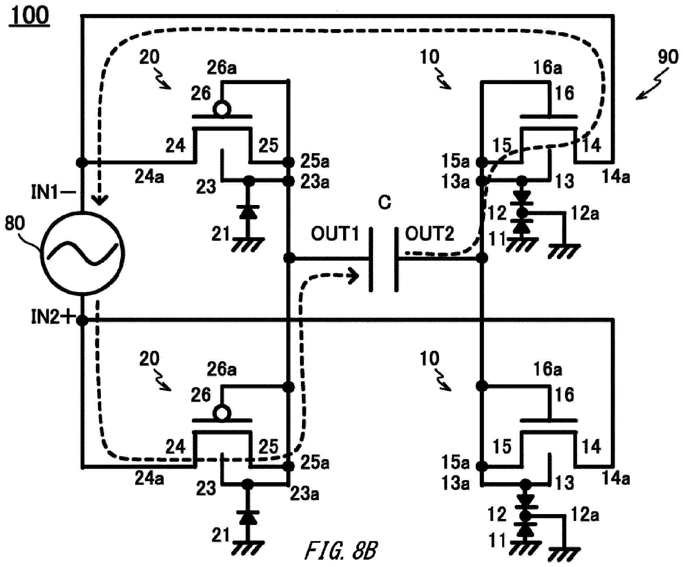

FIG. 8A and FIG. 8B illustrate principles of operation of the rectifying device 100 according to the present embodiment. As shown in FIG. 8A, if an AC signal with positive charges (+) is input to the input terminal IN1, and an AC signal with negative charges (-) is input to the input terminal IN2 by the AC signal generation source 80, the PMOSFET 20 located at an upper left portion in the figure and the NMOSFET 10 located at a lower right portion in the figure become electrically conductive; thereby, the positive charges are input to the output terminal OUT1, and the negative charges are input to the output terminal OUT2. Thereby, the AC output from the AC signal generation source 80 flows into the capacitative element C via the PMOSFET 20 located at an upper left portion in the figure, and is stored in the capacitative element C. In addition, as shown in FIG. 8B, if AC signals of opposite phases, that is, an AC signal with negative charges (-) is generated to the input terminal IN1, and an AC signal with positive charges (+) is generated for the input terminal IN2 by the AC signal generation source 80, the PMOSFET 20 located at a lower left portion in the figure and the NMOSFET 10 located at an upper right portion in the figure become electrically conductive; thereby, the positive charges are input to the output terminal OUT1, and the negative charges are input to the output terminal OUT2. Thereby, the AC output from the AC signal generation source 80 flows into the capacitative element C via the PMOSFET 20 located at a lower left portion in the figure, and is stored therein.

In this manner, AC signals output from the AC signal generation source 80 are subjected to full-wave rectification by the rectifying device 100. Note that, in the rectifying device 100, full-wave rectification to output positive potential to the output terminal OUT1 becomes possible by connecting the output terminal OUT2 to the ground, and full-wave rectification to output negative potential to the output terminal OUT2 becomes possible by connecting the output terminal OUT1 to the ground.

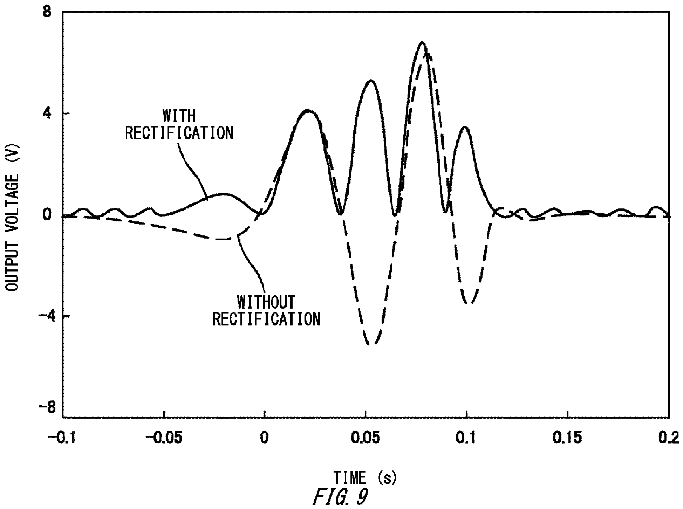

FIG. 9 illustrates an output waveform (solid line) that is observed when full-wave rectification is performed by the rectifying bridge circuit 90 included in the rectifying device 100 according to the present embodiment on an AC signal that is output using, as the AC signal generation source 80, a power generating element to convert AC signals in vibration power generation, that is, vibration into electrical power by electromagnetic induction. However, the capacitative element C is not connected between the output terminals OUT1 and OUT2 of the rectifying bridge circuit 90, and the potential difference across both terminals was measured in the state where those terminals are left unconnected. In the figure, an output waveform that is observed when rectification is not performed, that is, a signal (broken line) equal to an AC signal output from the AC signal generation source 80 is illustrated for comparison. While the output waveform (broken line) that is observed when rectification is not performed vibrates repeatedly showing both positive and negative amplitude over time, the output waveform (solid line) that is observed when full-wave rectification is performed vibrates repeatedly showing positive amplitude. Accordingly, this confirms that full-wave rectification has been performed on the AC signal by the rectifying bridge circuit 90.

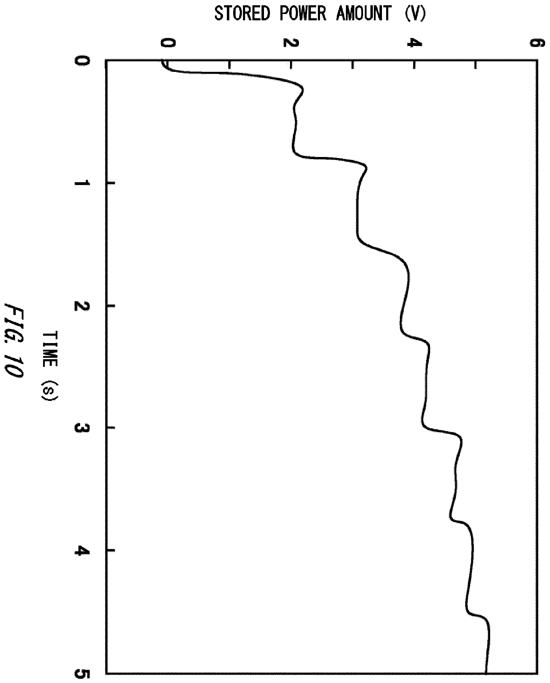

FIG. 10 illustrates changes in the amount of power stored by storing, in the capacitative element C using the rectifying device 100, AC signals in the above-mentioned vibration power generation. Here, a 100-µF capacitative element C is connected between the two output terminals OUT1 and OUT2 of the rectifying bridge circuit 90, and the output terminal OUT2 is connected to the ground. In the figure, the potential difference between both ends is shown as the power storage amount of the capacitative element C. It can be known that power is stored in the capacitative element C every time AC signals are rectified and output by the rectifying device 100 (rectifying bridge circuit 90), and so the power storage amount increases stepwise. Accordingly, this confirms that the rectifying device 100 according to the present embodiment can rectify AC signals and store power efficiently for the purpose of energy harvesting.

Note that, by using the NMOSFET 10 having a triple-well structure in the rectifying device 100, it becomes possible, for example, to connect the output terminal OUT1 to the ground, and perform full-wave rectification to output negative potential to the output terminal OUT2.

Note that although the NMOSFET 10 having a triple-well structure is used in the rectifying device 100, this is not the sole example, and for example if the output terminal OUT2 is connected to the ground, and full-wave rectification to output a positive voltage to the output terminal OUT1 is performed, the NMOSFET 10 may have a structure other than a triple-well structure.

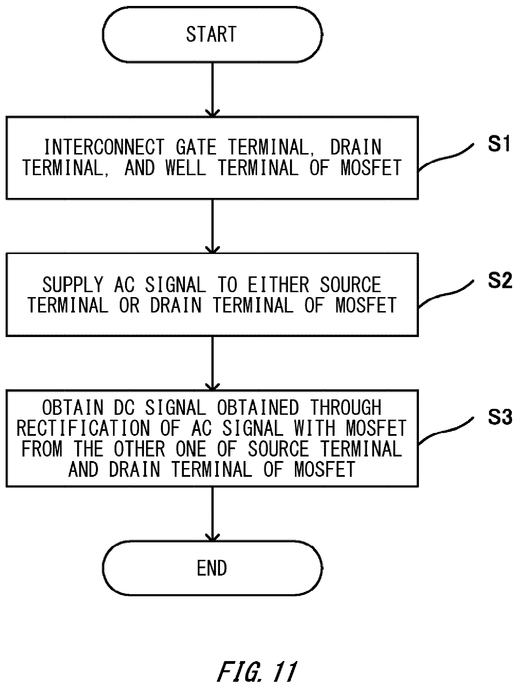

FIG. 11 illustrates the flow of a rectifying method performed by the rectifying device 100 according to the present embodiment.

At Step S1, a diode connection is established in a MOSFET. That is, as shown in FIG. 3, the gate terminal 16a, drain terminal 15a, and well terminal 13a of the NMOSFET 10 are interconnected to short-circuit the gate 16, drain 15, and p type well 13. In addition, as shown in FIG. 4, the gate terminal 26a, drain terminal 25a, and well terminal 23a of the PMOSFET 20 are interconnected to short-circuit the gate 26, drain 25, and n type well 23 are short-circuited. A MOSFET including these NMOSFET 10 and PMOSFET 20 is used to constitute the rectifying bridge circuit 90 shown in FIG. 7, and this is connected to the AC signal generation source 80 and capacitative element C to constitute the rectifying device 100.

At Step S2, an AC signal to cause the MOSFET to operate in a voltage region including a weak inversion region is generated by the AC signal generation source 80, and supplied to either the source terminal or drain terminal of the MOSFET (the source terminal of the MOSFET in the rectifying device 100).

At Step S3, a DC signal obtained through rectification of the AC signal with the MOSFET is obtained from the other one of the source terminal and the drain terminal (the drain terminal of the MOSFET in the rectifying device 100). Thereby, the DC signal flows into the capacitative element C, and stored therein.

Note that although the rectifying device 100 according to the present embodiment employs full-wave rectification, it may employ half-wave rectification.

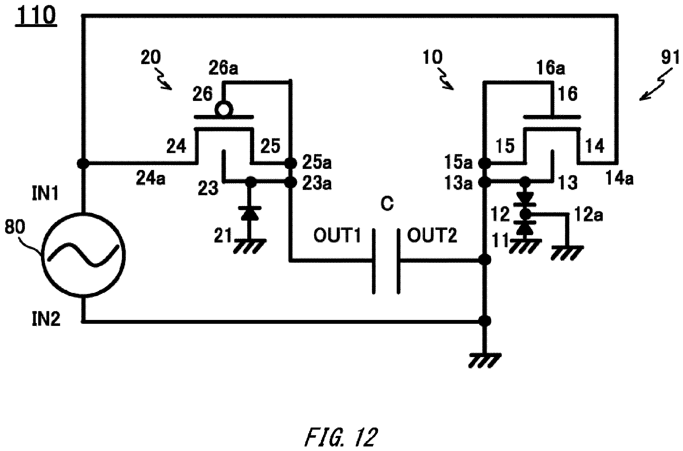

FIG. 12 illustrates the circuit configuration of a rectifying device 110 according to a first variant. The rectifying device 110 is an apparatus that performs half-wave rectification on AC signals and store power, and includes the AC signal generation source 80, a rectifying bridge circuit 91, and the capacitative element C. Here, the AC signal generation source 80 and capacitative element C are similar to those in the above-mentioned rectifying device 100.

The rectifying bridge circuit 91 is configured to include one NMOSFET 10 and one PMOSFET 20. The rectifying bridge circuit 91 has two input terminals IN1 and IN2, and two output terminals OUT1 and OUT2. The NMOSFET 10 has a source terminal 14a connected to the AC signal generation source 80 via the input terminal IN1, and has a drain terminal 15a connected to the capacitative element C via the output terminal OUT2. In addition, the NMOSFETs 10 has an isolation terminal 12a (an n type isolation region 12) connected to the ground. The PMOSFETs 20 has a source terminal 24a connected to the AC signal generation source 80 via the input terminal IN1, and has a drain terminal 25a connected to the capacitative element C via the output terminal OUT1. Furthermore, the input terminal IN2 and output terminal OUT2 are connected to the ground.

Note that at least one of (at least one MOSFET constituting) the rectifying bridge circuit 91 and the capacitative element C may be integrated on an energy harvesting IC (not illustrated).

If, in the rectifying device 110 with the above-mentioned configuration, an AC signal with positive charges is input to the input terminal IN1, and an AC signal with negative charges is input to the input terminal IN2 by the AC signal generation source 80, the NMOSFET 10 is cut off, and the PMOSFET 20 becomes electrically conductive; thereby, the positive charges are input to the output terminal OUT1. Thereby, the AC output from the AC signal generation source 80 flows into the capacitative element C via the PMOSFET 20, and is stored in the capacitative element C. In addition, if AC signals of opposite phases, that is, an AC signal with negative charges is input to the input terminal IN1, and an AC signal with positive charges is input to the input terminal IN2 by the AC signal generation source 80, the NMOSFET 10 becomes electrically conductive, and the PMOSFET 20 is cut off; thereby, the input terminals IN1 and IN2 are short-circuited, and the AC signals do not flow into the capacitative element C, but loop. In this manner, AC signals output from the AC signal generation source 80 are subjected to half-wave rectification by the rectifying device 110.

Note that a rectifying bridge circuit included in a rectifying device may be constituted using only the NMOSFET 10.

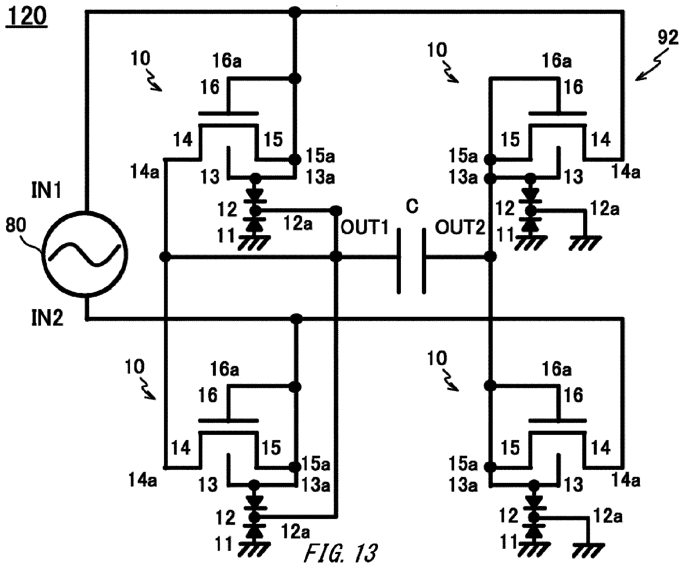

FIG. 13 illustrates the circuit configuration of a rectifying device 120 according to a second variant. The rectifying device 120 is an apparatus that performs full-wave rectification on AC signals and stores power, and includes the AC signal generation source 80, a rectifying bridge circuit 92, and the capacitative element C. Here, the AC signal generation source 80 and capacitative element C are similar to those in the above-mentioned rectifying devices 100, 110.

The rectifying bridge circuit 92 is configured to include four NMOSFETs 10. The rectifying bridge circuit 92 has two input terminals IN1 and IN2, and two output terminals OUT1 and OUT2, and between those terminals, diode bridge connections are established between the four NMOSFETs 10. The two NMOSFETs 10 located on the left side in the figure each have a drain terminal 15a connected to the AC signal generation source 80 via the input terminals IN1 and IN2, and have a source terminal 14a connected to the capacitative element C via the output terminal OUT1. In addition, these NMOSFETs 10 each have an isolation terminal 12a (that is, an n type isolation region 12) connected to the output terminal OUT1. The two NMOSFETs 10 located on the right side in the figure each have a source terminal 14a connected to the AC signal generation source 80 via the input terminals IN1 and IN2, and have a drain terminal 15a connected to the capacitative element C via the output terminal OUT2. In addition, the NMOSFETs 10 located at an upper right portion and a lower right portion in the figure each have an isolation terminal 12a (that is, an n type isolation region 12) connected to the ground or the output terminal OUT1 (in this case, connected to the ground, for example).

Note that at least one of (at least one MOSFET constituting) the rectifying bridge circuit 92 and the capacitative element C may be integrated on an energy harvesting IC (not illustrated).

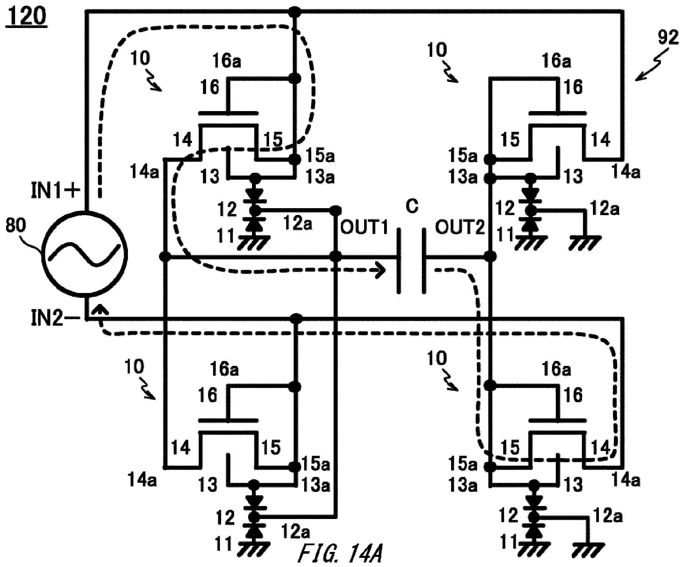

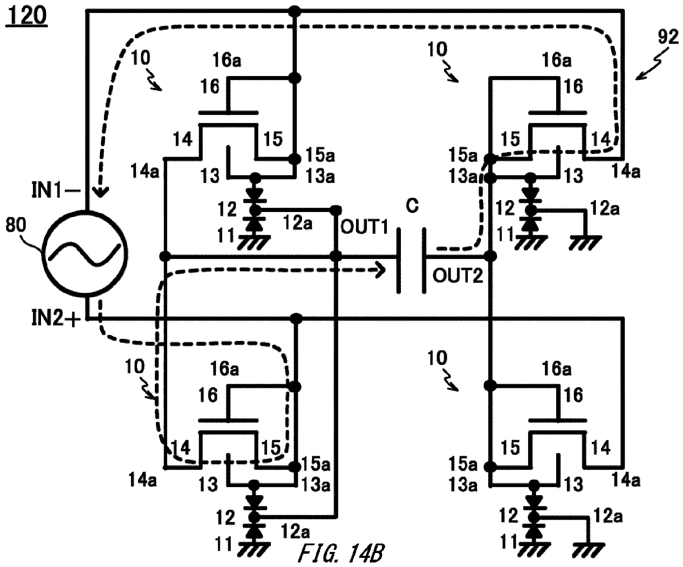

FIG. 14A and FIG. 14B illustrate principles of operation of the rectifying device 120 according to the present variant. As shown in FIG. 14A, if an AC signal with positive charges (+) is input to the input terminal IN1, and an AC signal with negative charges (-) is input to the input terminal IN2 by the AC signal generation source 80, the NMOSFET 10 located at an upper left portion in the figure and the NMOSFET 10 located at a lower right portion in the figure become electrically conductive; thereby, the positive charges are input to the output terminal OUT1, and the negative charges are input to the output terminal OUT2. Thereby, the AC output from the AC signal generation source 80 flows into the capacitative element C via the NMOSFET 10 located at an upper left portion in the figure, and is stored in the capacitative element C. In addition, as shown in FIG. 14B, if AC signals of opposite phases, that is, an AC signal with negative charges (-) is generated for the input terminal IN1, and an AC signal with positive charges (+) is generated for the input terminal IN2 by the AC signal generation source 80, the NMOSFET 10 located at a lower left portion in the figure and the NMOSFET 10 located at an upper right portion in the figure become electrically conductive; thereby, the positive charges are input to the output terminal OUT1, and the negative charges are input to the output terminal OUT2. Thereby, the AC output from the AC signal generation source 80 flows into the capacitative element C via the NMOSFET 10 located at a lower left portion in the figure, and is stored therein.

In this manner, AC signals output from the AC signal generation source 80 are subjected to full-wave rectification by the rectifying device 120. In particular, by using the NMOSFETs 10 having triple-well structures in the rectifying device 120, full-wave rectification to output positive potential to the output terminal OUT1 becomes possible by connecting the output terminal OUT2 to the ground, and full-wave rectification to output negative potential to the output terminal OUT2 becomes possible by connecting the output terminal OUT1 to the ground.

In the rectifying device 120 according to the present variant also, AC signals can be rectified to store power efficiently for the purpose of energy harvesting, similar to the above-mentioned rectifying device 100.

Note that although the rectifying device 120 according to the present variant employs full-wave rectification, it may employ half-wave rectification.

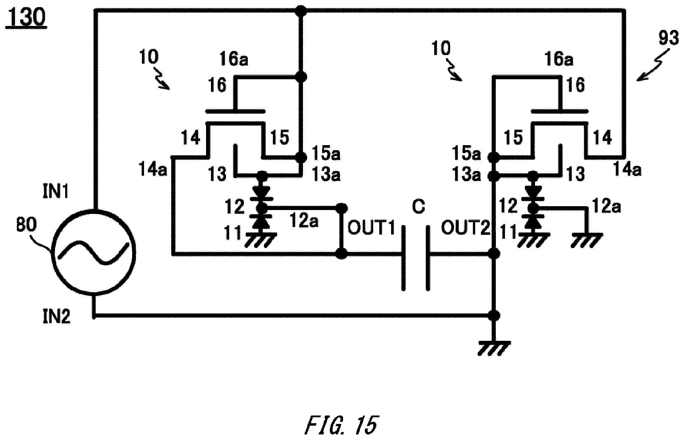

FIG. 15 illustrates the circuit configuration of a rectifying device 130 according to a third variant. The rectifying device 130 is an apparatus that performs half-wave rectification on AC signals and store power, and includes the AC signal generation source 80, a rectifying bridge circuit 93, and the capacitative element C. Here, the AC signal generation source 80 and capacitative element C are similar to those in the above-mentioned rectifying devices 100 to 120.

The rectifying bridge circuit 93 is configured to include two NMOSFETs 10. The rectifying bridge circuit 93 has two input terminals IN1 and IN2, and two output terminals OUT1 and OUT2. The NMOSFET 10 located on the left side in the figure has a drain terminal 15a connected to the AC signal generation source 80 via the input terminal IN1, and has a source terminal 14a connected to the capacitative element C via the output terminal OUT1. In addition, the NMOSFET 10 has an isolation terminal 12a (that is, an n type isolation region 12) connected to the output terminal OUT1. The NMOSFET 10 located on the right side in the figure has a source terminal 14a connected to the AC signal generation source 80 via the input terminal IN1, and have a drain terminal 15a connected to the capacitative element C via the output terminal OUT2. In addition, the NMOSFETs 10 has an isolation terminal 12a (that is, an n type isolation region 12) connected to the ground. Furthermore, the input terminal IN2 and output terminal OUT2 are connected to the ground.

Note that at least one of (at least one MOSFET constituting) the rectifying bridge circuit 93 and the capacitative element C may be integrated on an energy harvesting IC (not illustrated).

If, in the rectifying device 130 with the above-mentioned configuration, an AC signal with positive charges is input to the input terminal IN1, and an AC signal with negative charges is input to the input terminal IN2 by the AC signal generation source 80, the NMOSFET 10 on the right side in the figure is cut off, and the NMOSFET 10 on the left side in the figure becomes electrically conductive; thereby, the positive charges are input to the output terminal OUT1. Thereby, the AC output from the AC signal generation source 80 flows into the capacitative element C via the NMOSFET 10 located on the left side, and is stored in the capacitative element C. In addition, if AC signals of opposite phases, that is, an AC signal with negative charges is input to the input terminal IN1, and an AC signal with positive charges is input to the input terminal IN2 by the AC signal generation source 80, the NMOSFET 10 on the right side in the figure becomes electrically conductive, and the NMOSFET 10 on the left side in the figure is cut off; thereby, the input terminals IN1 and IN2 are short-circuited, and the AC signals do not flow into the capacitative element C, but loop. In this manner, AC signals output from the AC signal generation source 80 are subjected to half-wave rectification by the rectifying device 130.

Note that a rectifying bridge circuit included in a rectifying device may be constituted using only the PMOSFET 20.

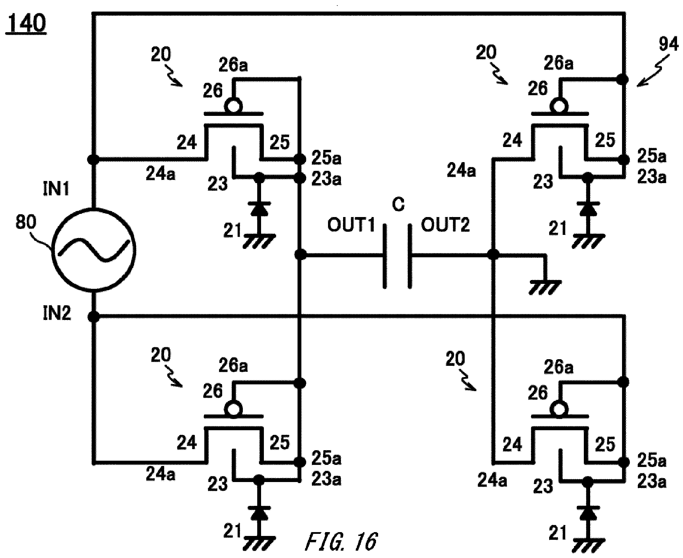

FIG. 16 illustrates the circuit configuration of a rectifying device 140 according to a fourth variant. The rectifying device 140 is an apparatus that performs full-wave rectification on AC signals and store power, and includes the AC signal generation source 80, a rectifying bridge circuit 94, and the capacitative element C. Here, the AC signal generation source 80 and capacitative element C are similar to those in the above-mentioned rectifying devices 100 to 130.

The rectifying bridge circuit 94 is configured to include four PMOSFETs 20. The rectifying bridge circuit 94 has two input terminals IN1 and IN2, and two output terminals OUT1 and OUT2, and between those terminals, diode bridge connections are established between the four PMOSFETs 20. The two PMOSFETs 20 located on the left side in the figure each have a source terminal 24a connected to the AC signal generation source 80 via the input terminals IN1 and IN2, and has a drain terminal 25a connected to the capacitative element C via the output terminal OUT1. The two PMOSFETs 20 located on the right side in the figure each have a drain terminal 25a connected to the AC signal generation source 80 via the input terminals IN1 and IN2, and have a source terminal 24a connected to the capacitative element C via the output terminal OUT2. Furthermore, the output terminal OUT2 are connected to the ground.

Note that at least one of (at least one MOSFET constituting) the rectifying bridge circuit 94 and the capacitative element C may be integrated on an energy harvesting IC (not illustrated).

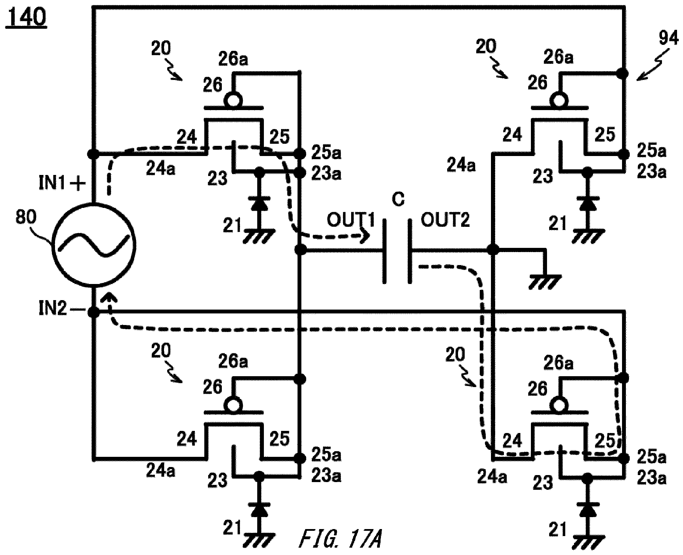

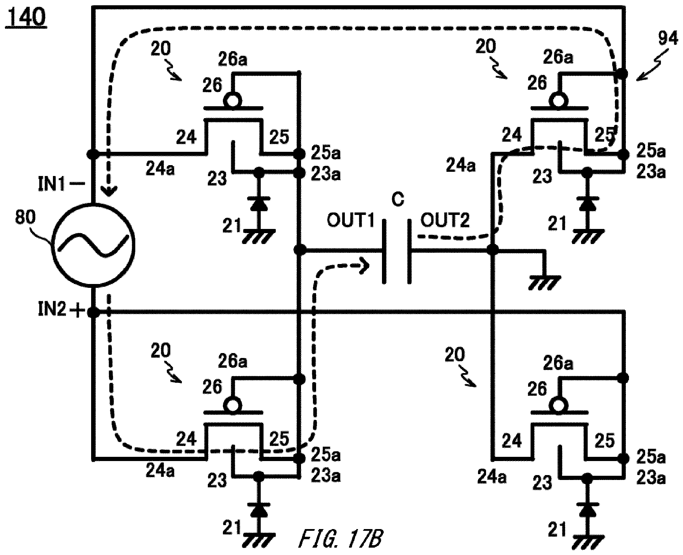

FIG. 17A and FIG. 17B illustrate principles of operation of the rectifying device 140 according to the present variant. As shown in FIG. 17A, if an AC signal with positive charges (+) is input to the input terminal IN1, and an AC signal with negative charges (-) is input to the input terminal IN2 by the AC signal generation source 80, the PMOSFET 20 located at an upper left portion in the figure and the PMOSFET 20 located at a lower right portion in the figure become electrically conductive; thereby, the positive charges are input to the output terminal OUT1. Thereby, the AC output from the AC signal generation source 80 flows into the capacitative element C via the PMOSFET 20 located at an upper left portion in the figure, and is stored in the capacitative element C. In addition, as shown in FIG. 17B, if AC signals of opposite phases, that is, an AC signal with negative charges (-) is generated for the input terminal IN1, and an AC signal with positive charges (+) is generated for the input terminal IN2 by the AC signal generation source 80, the PMOSFET 20 located at a lower left portion in the figure and the PMOSFET 20 located at an upper right portion in the figure become electrically conductive; thereby, the positive charges are input to the output terminal OUT1. Thereby, the AC output from the AC signal generation source 80 flows into the capacitative element C via the PMOSFET 20 located at a lower left portion in the figure, and is stored therein. In this manner, AC signals output from the AC signal generation source 80 are subjected to full-wave rectification by the rectifying device 140.

Note that about the two PMOSFETs 20 located on the right side in the figure, the output terminal OUT2 needs to be at the ground potential such that the forward potential is not applied to the PN junction between the p type semiconductor substrate and the n type well 23; therefore, the rectifying device 140 has a configuration to output only positive potential. By using, instead of the PMOSFETs 20, a MOSFET in which a p type isolation region and an n type well are stacked on an n type semiconductor substrate, and the isolation region isolates the well from the substrate, or a MOSFET in which an n type region, a p type region, and an n type well are formed on a p type semiconductor substrate, and the n type region and p type region isolate the well from the substrate, it is possible to constitute a rectifying bridge circuit that outputs both positive potential and negative potential.

In the rectifying device 140 according to the present variant also, AC signals can be rectified to store power efficiently for the purpose of energy harvesting, similar to the above-mentioned rectifying device 100.

Note that although the rectifying device 140 according to the present variant employs full-wave rectification, it may employ half-wave rectification.

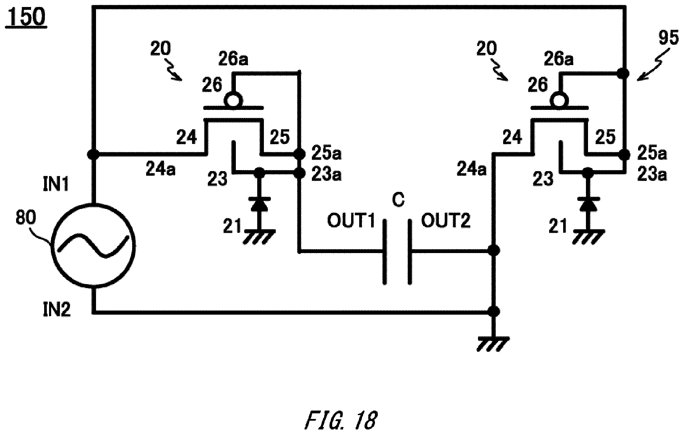

FIG. 18 illustrates the circuit configuration of a rectifying device 150 according to a fifth variant. The rectifying device 150 is an apparatus that performs half-wave rectification on AC signals and store power, and includes the AC signal generation source 80, a rectifying bridge circuit 95, and the capacitative element C. Here, the AC signal generation source 80 and capacitative element C are similar to those in the above-mentioned rectifying devices 100 to 140.

The rectifying bridge circuit 95 is configured to include two PMOSFETs 20. The rectifying bridge circuit 95 has two input terminals IN1 and IN2, and two output terminals OUT1 and OUT2. The PMOSFETs 20 located on the left side in the figure has a source terminal 24a connected to the AC signal generation source 80 via the input terminal IN1, and has a drain terminal 25a connected to the capacitative element C via the output terminal OUT1. The PMOSFET 20 located on the right side in the figure has a drain terminal 25a connected to the AC signal generation source 80 via the input terminal IN1, and has a source terminal 24a connected to the capacitative element C via the output terminal OUT2. Furthermore, the input terminal IN2 and output terminal OUT2 are connected to the ground.

Note that at least one of (at least one MOSFET constituting) the rectifying bridge circuit 95 and the capacitative element C may be integrated on an energy harvesting IC (not illustrated).

If, in the rectifying device 150 with the above-mentioned configuration, an AC signal with positive charges is input to the input terminal IN1, and an AC signal with negative charges is input to the input terminal IN2 by the AC signal generation source 80, the PMOSFET 20 on the right side in the figure is cut off, and the PMOSFET 20 on the left side in the figure becomes electrically conductive; thereby, the positive charges are input to the output terminal OUT1. Thereby, the AC output from the AC signal generation source 80 flows into the capacitative element C via the PMOSFET 20 located on the left side, and is stored in the capacitative element C. In addition, if AC signals of opposite phases, that is, an AC signal with negative charges is input to the input terminal IN1, and an AC signal with positive charges is input to the input terminal IN2 by the AC signal generation source 80, the PMOSFET 20 located on the right side in the figure becomes electrically conductive, and the PMOSFET 20 located on the left side in the figure is cut off; thereby, the input terminals IN1 and IN2 are short-circuited, and the AC signals do not flow into the capacitative element C, but loop. In this manner, AC signals output from the AC signal generation source 80 are subjected to half-wave rectification by the rectifying device 150.

The rectifying bridge circuits 90 to 95 included in the rectifying device 100 according to the present embodiment and the rectifying devices 110 to 150 according to the variants use, as a rectifying element, a MOSFET that is driven even in a weak inversion region by short-circuiting the gate, drain, and well, and so have low rectification loss, and small leakage current; therefore, they can constitute rectifying devices that are highly efficient, have low leakage current, can cope with high frequency, and thus are suitable for energy harvesting technologies to collect very weak energy. In addition, using a planar gate MOSFET eliminates necessity for discrete components, and it becomes possible to integrate it with another integrated circuit such as a power supply IC.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

### [Explanation of Reference Symbols]

10: NMOSFET; 11: p type semiconductor substrate; 12: n type isolation region; 12a: isolation terminal; 13: p type well; 13a: well terminal; 14: source; 14a: source terminal; 15: drain; 15a: drain terminal; 16: gate; 16a: gate terminal; 17: insulating film; 18: spacer; 20: PMOSFET; 21: p type semiconductor substrate; 23: n type well; 23a: well terminal; 24: source; 24a: source terminal; 25: drain; 25a: drain terminal; 26: gate; 26a: gate terminal; 27: insulating film; 28: spacer; 80: AC signal generation source; 90 to 95: rectifying bridge circuit; 100 to 150: rectifying device; IN1, IN2: input terminal; OUT1, OUT2: output terminal

## Claims

1. A rectifying method comprising:
supplying an AC signal to cause a MOSFET having a gate terminal, a drain terminal, and a well terminal that are interconnected to operate in a voltage region including a weak inversion region to one of a source terminal and the drain terminal of the MOSFET; and
obtaining a DC signal obtained through rectification of the AC signal by the MOSFET from the other one of the source terminal and the drain terminal.

2. The rectifying method according to claim 1, wherein reverse leakage current of the MOSFET is smaller than 1 nA.

3. The rectifying method according to claim 1 or 2, wherein the MOSFET is integrated on an energy harvesting IC.

4. A rectifying device comprising:
at least one MOSFET having a gate terminal, a drain terminal, and a well terminal that are interconnected;
an AC signal generation source that generates an AC signal to cause the at least one MOSFET to operate in a voltage region including a weak inversion region, and supplies the AC signal to one of a source terminal and the drain terminal of the MOSFET; and
a capacitative element connected to the other one of the source terminal and the drain terminal.

5. The rectifying device according to claim 4, wherein reverse leakage current of the at least one MOSFET is smaller than 1 nA.

6. The rectifying device according to claim 4 or 5, wherein the at least one MOSFET is integrated on an energy harvesting IC.

7. The rectifying device according to claim 6, wherein the capacitative element is integrated on the energy harvesting IC.

8. The rectifying device according to any one of claims 4 to 7, wherein the at least one MOSFET includes a MOSFET having a well which is connected to the well terminal, the well being isolated from a substrate.

9. The rectifying device according to any one of claims 4 to 8, wherein the at least one MOSFET includes two NMOSFETs and two PMOSFETs between which diode bridge connections are established.

10. The rectifying device according to any one of claims 4 to 8, wherein the at least one MOSFET includes four NMOSFETs between which diode bridge connections are established.

11. The rectifying device according to claim 10, wherein
at least one of the four NMOSFETs has an isolation region that isolates a well connected to the well terminal from a substrate, and
the isolation region is connected to one end of the capacitative element.

12. The rectifying device according to any one of claims 4 to 8, wherein the at least one MOSFET includes four PMOSFETs between which diode bridge connections are established.
